# EUROPEAN PATENT APPLICATION

(11) **EP 1 473 760 A2**
(43) Date of publication of application: **03.11.2004**
(21) Application number: 04460012.0
(22) Date of filing: 23.04.2004
(51) Int. Cl.: H01L 21/027

(54) **Technique for nano-lines fabrication**

(30) Priority: 24.04.2003 PL 35983803
(71) Applicant: Instytut Technologii Elektronowej, 02-668 Warszawa (PL)
(72) Inventor: Rangelow, Iwajlo, 34225 Baunatal (DE); Grabiec, Piotr, 02-795 Warszawa (PL); Zaborovski, Michel, 03-833 Warszawa (PL); Domanski, Krzysztof, 05-500 Warszawa (PL)

(57) **Abstract**

A subject of the invention is technique for fabrication of nano-width lines with with in the range down to single nanometers for application in nano- and micro-technology. In this technique first a base layer (3) coated with a protective layer (4) is formed on a substrate (1). Next, a pattern defining a path along the future nano-lines will be created is formed in both layers using lithography opening at the same time access to sidewall (5) of the base layer (3). Furthermore the structure is treated with a known physico-chemical process transforming the near-edge volume of the base layer (3) to the form resistant to physico-chemical processes which removes the not transformed base layer (3) and protective layer (4). Next, the not transformed base layer (3) and protective layer (4) is removed leaving a narrow line of the transformed base layer material of width related to extent of the transformation process.

## Description

A subject of the invention is technique for easy fabrication of nano-width lines in silicon dioxide or other materials. Nano-lines with different shapes and width down to single nanometers may be used as components of micro- and nano-electronic structures.

A base of contemporary microelectronics and micro-engineering consists in ability to define and create narrow lines in different materials on or in a (typically silicon) substrate. Level of the technology is often defined by a width of the narrowest line which may be formed using said technology. At the turn of 70/80 of the last century a classical photolithography was used for pattern definition. In this technique a silicon wafer coated with photosensitive material (photoresist) was exposed to light through a mask i.e. a transparent plate (quartz) with opaque pattern (chromium). Next, in the development process exposed (or unexposed, depending on type of the process) photoresist has been removed opening access to the underlaying material (e.g. silicon dioxide). In consecutive step the oxide underwent the selective processing in which lines or shapes of the desired dimensions were etched in the oxide. Many applications and variation of this basic technique have been worked out however, this technique has still serious limitations. Because of light interference and diffraction it allows for creation of pattern with a minimum dimensions down to 3µm (if mask and substrate are in proximity to decrease defect density) or to approx. 0.5µm where they are in direct contact (not suitable for industrial applications).

The solution introduced with great success to industry was a step-and-repeat technique in which a (typically) 5x magnified fragment of the pattern with size in the range of 1 - 5 cm² was transferred in the exposition process from the mask to the photoresist coated wafer by means of a special optical 5:1 reduction system. The pattern covers only part of the substrate thus a step-and-repeat procedure has to be implemented to expose whole wafer.

The step-and repeat technique was refined during last twenty years by introduction of laser interferometry, ultra-violet light and sophisticated masks and photosensitive materials. It allowsfor fabrication in mass production environment patterns down to 0.15µm. At present manufacturing of patterns as narrow as 100 nm (0.1µm) is foreseen. The 100 nm is however a limit below which the light based optical step-and-repeat techniques fail. Additional, important barrier is a prohibitively high cost of the necessary tools. While proximity aligner tool for 3µm technology costs approx. 100 000 USD, machine for patterning at 0.35 µm level requires 1 - 2 mln USD investment and the state of the art aligner enabling fabrication of 100 - 150 nm pattern reach 5 mln USD for one machine. Additional factor is extremely high cost of maintenance and very expensive sophisticated masks.

A solution often used for advanced research application is an e-beam lithography technique, in which pattern is formed on the resist coated substrate by means of the electron beam directly writing lines in the e-beam sensitive resist film. The path of the electron beam is controlled in the manner similar as in a scanning electron microscope. The technique, while enable pattern formation well below 100nm is also very slow (processing of a single wafer takes even few hours, whereas in optical step-and-repeat machine it takes only few minutes) and thus it is not suitable for mass production. The low speed of the process predestine it to R&D application. Moreover, due to electron scattering in photoresist, the e-beam writing technique is very difficult below 20 nm.

The tremendous progress of microelectronics has led the microelectronic industry to the limits of the existing lithography techniques. In consequence an enormous effort is undertaken to develop a new technique which would allow for high throughput pattern definition well below 100 nm limit. Different physical phenomena are used for this purpose. It is considered in these so called Next Generation Lithography techniques to replace light in the step-and-repeat technique with a wide, un-collimated electron beam or ion beam covering part of the mask. To increase writing speed in the e-beam technique an array of miniature e-beam guns, working and drawing the pattern in parallel is being developed.

A group of innovative techniques being under development recently is based on utilization of an AFM (Atomic Force Microscopy ) type micro-tip, writing pattern on the wafer utilizing variety of physical or chemical phenomena. The microtip located at the end of a cantilever micro-beam, precisely driven by means of a set of piezo-electric actuators is used as a source of electrons emitted from the tip and affecting local properties of the underlying structure (e.g. oxidizing surface of the sample). In other innovative solution the microtip is pressed mechanically into surface of a soft polymer coating the silicon wafer and thus creating a pattern. In both micro-tip based techniques multiple tip device has to be developed to increase writing speed. The task involves difficult, precise control of deflection of each cantilever and independent signal control for each tip. Up to now these techniques are still in the early development stage and are not generally accepted. Because of the complexity of the multiple tip device it may be expected, that the tool for writing nano-pattern using this technique will be also very expensive. Besides, it is expected that 10 nm will be a limit for these techniques.

The aim of this invention is elaboration of a method for fabrication of pattern in the form of the nano-lines with deep submicron width, even down to single nanometers range.

The invented technique consists in creation on the surface of a substrate a base layer which is an initial material for the future nano-line, followed by coating with a protective layer. In a next step a pattern is created in the both layers, favourably by means of a lithography. Edges of the pattern delineate location of the future nano-lines and expose sidewall of the bottom (base) material. The exposed base material is then treated with a known physico-chemical process in which the edge area of the base layer material undergo a transformation to a form in which it is resistant to a physico-chemical agents removing a protective layer and the not transformed material of the base layer. Next, the protective layer and the base, not transformed layers are removed.

In this process a thin silicon film, monomer or a polymer may be used as the base layer. The protective layer may be a silicon nitride (in the case of silicon used as a base layer) film. Depending on the chosen type of the base material its exposed edge is treated by oxidation, polymerization or poly-condensation processes. After the transformation process is finished the protective layer and not transformed base layer are removed by means of etching, sublimation or dissolving, depending on the combination of the chosen materials. The invention is explained using example shown in the following figures.

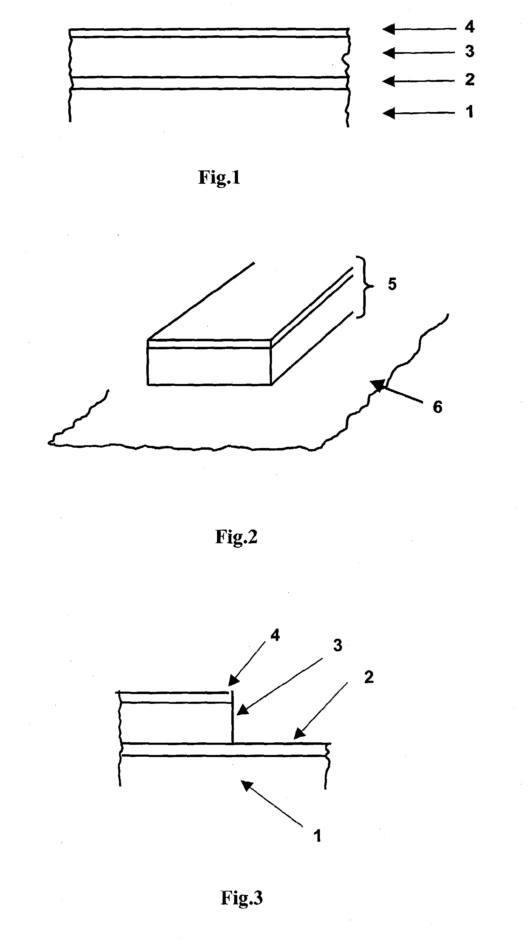

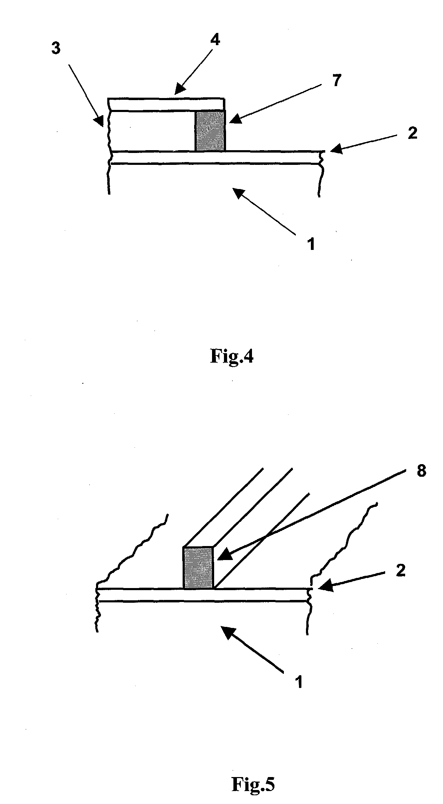

Fig. 1. shows a cross-section of a structure consisting of a silicon substrate after deposition of base and protective layers. In Fig.2. a structure after definition of the future nano-line paths and the exposed edge of the base layer is presented. The same stage of the process is shown as a cross-section in Fig.3. Fig.4. shows a cross-section of the structure after transformation of the base layer by means of a physico-chemical process. Final nano-line left after removing of the protective and base (not-transformed) layers is shown in Fig.5.

Thus, in the first step a thin, base, transformation susceptible layer 3 is formed at the surface 1 and next a thin protective layer 4 which do not undergo the transformation is created onto or in the top part of the base layer 3. It is important also, that the surface of the substrate 1 has to be resistant to the transformation process or its transformation is negligible. The substrate with both layers 3 and 4 is processed using a classical photolithography (e.g. proximity or stepper technique) in which a pattern defining a path along which a future nano-lines will be created (and not - width) is formed. Next, the structure is processed in an etching process. The etching has to be optimized to ensure a vertical slope of the etched edge. In a following sequence the wafer is treated with a process to transform the exposed sidewall of the base layer 3. It has to be emphasized, that the transformation process proceeds from the surface of the exposed sidewall inside the base layer in a well controlled manner. The protective layer 4 protects top of the base layer against the transforming agent (e.g. oxygen), so that the transformation is limited to the sidewall only. The transformation rate and time of the process precisely define width of the transformed area 7 of the base layer 3 and, as the consequence - width of the fabricated nano-line. In the next processing step the protective layer 4 and not-transformed base layer 3 is removed by means of an etching process. Thus, a near edge volume of the base layer 3 transformed to the etching resistant form remains at the surface.

In a first example a thin (300 nm) base layer 3 of fine-gain polycrystalline silicon has been deposited using Low Pressure Chemical Vapor Deposition (LPCVD) on a silicon substrate 1 coated with silicon nitride film 2. Next, the base layer 3 was coated with a 40nm protective silicon nitride layer 4 using again the LPCVD deposition technique and shape delineating future nano-line paths was created using a standard photolithography. The edge 5 of the layer 3 laying on the nitride layer 2 coated substrate 1 was exposed by means of etching process. Furthermore, the exposed sidewall of the polysilicon material 5 was treated with thermal oxidation in which the silicon is transformed into silicon dioxide. A direction f the oxidation process is indicated by arrow 6. The top surface of the layer 3 is protected by silicon nitride which is oxidation resistant material. Temperature, composition of a gas mixture and time of the oxidation process define precisely progress of the reaction and consequently, a width f the future silicon dioxide line.

In the following step the protective silicon nitride layer 4 and not transformed polysilicon 3 are removed by RIE plasma etching in CF₄ + O₂ and next, in SF₆ + O₂ atmosphere, selectively with regard to silicon dioxide. As a result a nano-line 8 is formed in the silicon dioxide (Fig.5). Height of the line depends on the thickness of the initial polysilicon layer and width depends on the conditions and time of the oxidation process.

Considering a kinetics and very good control of the oxidation it is possible to fabricate lines with a width of 10 nm and even below using this technique. The silicon dioxide line may be used as a masking area in a subsequent doping or etching technological process.

In a second example the role of the base layer 3 was performed by lightly crosslinked polymer (or monomer) formed by spin-coating at room temperature. The material of the base layer consisted of a poly-isoprene derivative polymer. Next, the protective silicon dioxide layer 4_was formed using low temperature sputtering technique. Alternatively another metal or polymer film may be used for this purpose, however its properties have to ensure resistance to a cross-linking procedure used in a following steps. Next the shape of the nano-line paths was delineated by means of the standard photolithography followed by plasma etching. In this way a layered structure with exposed side-wall 5 of the layer 3 and top surface protected by means of the layer 4 was formed. This structure was exposed to a networking agent, in this example a gaseous compounds of sulphur. As a result the edge area of the base layer underwent further polymerization. The range of this transformation was defined by the process conditions and time. In the last processing steps a top protective layer was removed by etching in diluted HF while the not-transformed polymer was removed in a solvent. As a result of these operations we obtain a line pattern formed in the polymer with a width defined by the conditions and time of the performed cross-linking process.

In similar manner a novolak resins mixed with a cross-linking agent sensitive to water vapor (e.g. keten) or acid vapor may be used as a base materials and next, after opening access to the sidewall 5 the structure may be exposed to an atmosphere containing acid or water vapor. In the last operation the not cross-linked base material has to be removed by dissolution I solvent, remaining nano-lines 8.

## Claims

1. A method of fabrication of nano-lines **characterized in that** a base layer (3) is formed on a substrate (1) followed by formation of protective layer (4) on the base layer (3) and by creation in layer (3) and (4), favorably by means of photolithography, a pattern, whose edge defines shape of the future nano-lines and opens access to sidewall (5) of the base layer (3), subsequently the uncovered sidewall (5) is treated with an known physico-chemical process in which the near-edge volume of the sidewall of the base layer (3) is transformed to a form resistant to physico-chemical process removing protective layer (4) and not-transformed volume of the base layer (3), then the protective layer (4) and not-transformed base layer (3) is removed.

2. The method of Claim 1 wherein a base layer (3) is created at the substrate (1) in the form of silicon film, then layer (3) is coated with a protective layer (4) in the form of silicon nitride, next, sidewall (5) of the layer (3) exposed after defining of the shape of the future nano-lines is treated with a oxidation process, after which the protective layer (4) and not oxidized silicon of layer (3) is removed.

3. The method of Claim 1 wherein the base layer (3) is formed on the substrate (1) in the form of a lightly cross-linked polymer and next, the uncovered sidewall (5) of the base layer (3) is being cross-linked in the polymerization process.

4. The method of Claim 1 wherein the base layer (3) is formed on the substrate (1) in the form of a monomer and next, the uncovered sidewall (5) of the base layer (3) is being cross-linked in the polymerization process.

5. The method of Claim 1 wherein the base layer (3) is formed on the substrate (1) in the form of a polymer and next, the uncovered sidewall (5) of the base layer (3) is being cross-linked in the poly-condensation process.

6. The method of Claim 1 and 2 wherein the base layer (3) is composed of a monomer and next, the uncovered sidewall (5) of the base layer (3) is being cross-linked in the poly-condensation process.

7. The method of Claim 1,2,3,4,5 and 6 wherein removing of the protective layer (4) and not-transformed layer (3) is performed by etching.

8. The method of Claim 1,3,4,5 and 6 wherein removing of the protective layer (4) and not-transformed layer (3) is performed by sublimation.

9. The method of Claim 1,3,4,5 and 6 wherein removing of the protective layer (4) and not-transformed layer (3) is performed in solvent.
